# FASCICULE DE BREVET EUROPEEN

(11) **EP 0 850 960 B1**
(45) Date de publication et mention de la délivrance du brevet: **07.05.2003**
(21) Numéro de dépôt: 97403094.2
(22) Date de dépôt: 19.12.1997
(51) Int. Cl.: C08F 8/30

(54) **Polymères injecteurs de trous photopolymérisables et application en visualisation**
Photopolymerisierbare Lochübertragende Polymere und Anwendung zur Bilddarstellung
Photopolymerizable hole transferring polymers and use thereof for visualization

(30) Priorité: 24.12.1996 FR 9615936
(43) Date de publication de la demande: 01.07.1998
(73) Titulaire: Thales, 75008 Paris (FR)
(72) Inventeur: Le Barny, Pierre, 94117 Arcueil Cedex (FR); Soyer, Françoise, 94117 Arcueil Cedex (FR); Facoetti, Hugues, 94117 Arcueil Cedex (FR)

(56) Documents cités:
- EP-A- 0 386 571
- EP-A- 0 514 750
- DE-A- 2 111 415
- PATENT ABSTRACTS OF JAPAN vol. 096, no. 001, 31 janvier 1996 & JP 07 234415 A (TOMOEGAWA PAPER CO., LTD.), 5 septembre 1995,

## Description

L'invention concerne des polymères capables d'être réticulés photochimiquement, et particulièrement adaptés pour injecter des trous dans un matériau électroluminescent, pouvant être utilisé en visualisation.

Actuellement, le marché des écrans de visualisation est dominé par les tubes cathodiques. Mais ceux-ci, malgré leurs nombreux avantages souffrent d'un certain nombre de limitations comme leur encombrement, leur poids et la difficulté d'obtenir des écrans courbes de forme complexe et de grande dimension.

L'électroluminescence (émission non thermique de, lumière par un solide parcouru par un courant électrique) basée sur l'utilisation de polymères apparaît aujourd'hui comme étant la technologie susceptible de pallier les insuffisances des tubes cathodiques. En effet :
- le principe même de fonctionnement des écrans électroluminescents requiert l'emploi du matériau en film très mince (< 1 µm) et donc conduit à des afficheurs plats et légers ;
- le dépôt de polymère électroluminescent par centrifugation présente les avantages d'être peu coûteux, de conduire à des écrans courbes (lorsqu'un substrat souple est utilisé) et d'accéder à des écrans de grande dimension ;
- enfin le polymère est susceptible d'être gravé, ce qui ouvre de nombreuses perspectives dans la réalisation d'écrans complexes.

Par ailleurs, comparés aux écrans à cristaux liquides, les écrans électroluminescents offrent un meilleur angle de vue, une mise en oeuvre plus simple (pas de couche d'alignement) et ne requiert pas de rétroéclairage.

Pour générer l'électroluminescence, le matériau organique est inséré entre deux électrodes de nature différente. L'une des électrodes (cathode) injecte des électrons, l'autre (anode) injecte des trous. La recombinaison des électrons et des trous crée des excitons. 25 % des excitons ainsi formés sont singulets et 75 % sont triplets. Seule la désactivation des excitons singulets est radiative, ce qui limite le rendement quantique d'électroluminescence à 0,25 η (η étant le rendement de photoluminescence du matériau).

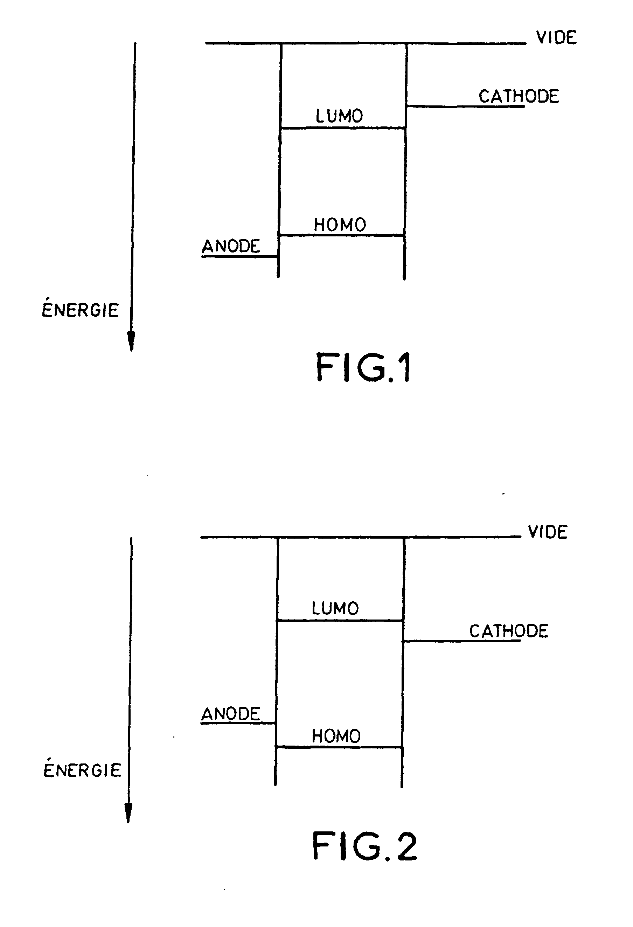

Idéalement, pour obtenir des injections de porteur efficaces, il faut que le travail d'extraction de l'anode soit supérieur au niveau énergétique de la HOMO (Highest Occupied Molecular Orbital) du matériau et que le travail d'extraction de la cathode soit inférieur au niveau énergétique de la LUMO (Lowest Unoccupied Molecular Orbital) du matériau, comme illustré en figure 1.

Mais les matériaux organiques électroluminescents connus à ce jour sont caractérisés par une LUMO de relativement faible énergie et une HOMO de forte énergie, comme l'illustre la figure 2. Par conséquent, les cathodes sont réalisées avec des métaux de faible travail d'extraction (Ca, Mg, Sm, Al) et les anodes avec des matériaux de travail d'extraction élevé. La nécessité supplémentaire d'avoir une électrode transparente fait que l'oxyde d'indium et d'étain (ITO) est généralement choisi pour réaliser l'anode.

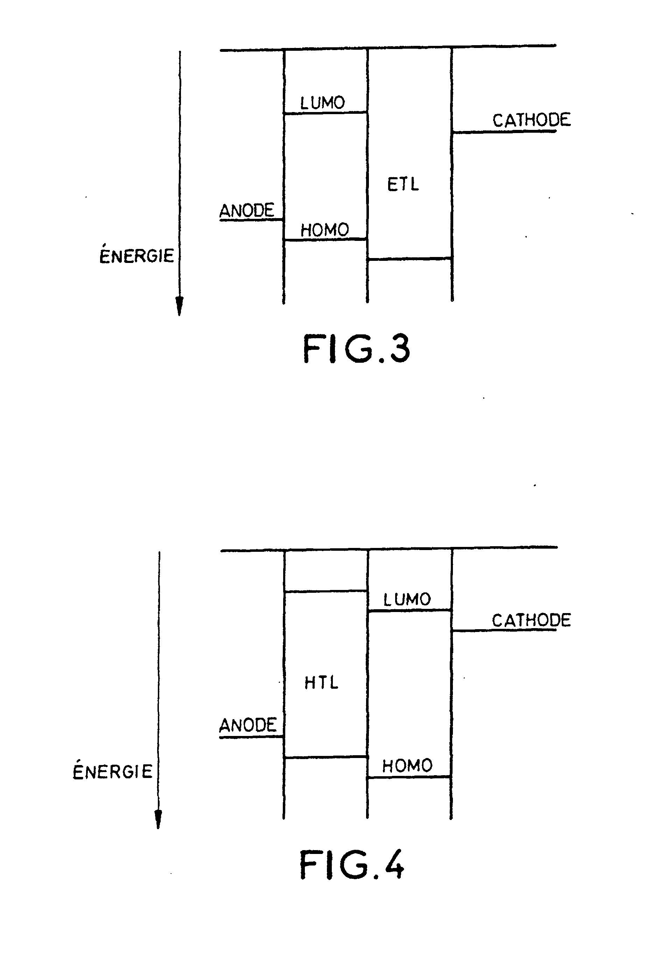

Pour obtenir un rendement énergétique élevé, il faut que les nombres d'électrons et de trous injectés soient égaux. Lorsque cette condition n'est pas réalisée, les porteurs majoritaires peuvent circuler dans le matériau et créent par effet Joule une élévation de température du matériau et concourrent à sa dégradation. On utilise dans ce cas des couches intermédiaires ayant pour fonction de faciliter l'injection d'électrons et de bloquer le passage des trous comme l'illustre la figure 3 avec le matériau ETL, ou bien de faciliter l'injection de trous et de bloquer le passage comme l'illustre la figure 4 avec le matériau HTL.

Les systèmes de visualisation utilisant des matériaux électroluminescents sont généralement construits par dépôt sur un substrat recouvert d'ITO :
- du matériau électroluminescent seul ;
- ou d'une couche injectrice de trous puis d'une couche émettrice ;
- ou d'une couche émettrice puis d'une couche injectrice d'électrons ;
- ou d'une couche injectrice de trous puis d'une couche émettrice puis d'une couche injectrice d'électrons.

Dans tous les cas, le dépôt de la cathode se fait en dernière étape sous vide.

Le dépôt de la couche injectrice peut se faire par évaporation sous de petites molécules de type : 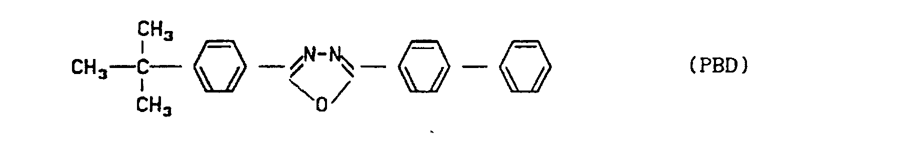 ou par centrifugation d'une solution de polymère amorphe sur le film de polymère émetteur.

L'évaporation de petites molécules injectrices d'électrons n'impose aucune contrainte sur les matériaux mis en jeu. Il n'en est pas de même dans le cas du dépôt par centrifugation. En effet, dans ce cas, il faut que le solvant d'enduction soit un non solvant du polymère émetteur. Ceci est aisément réalisé avec le PPV 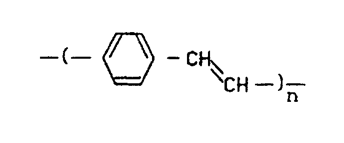 (qui est insoluble dans tous les solvants) et avec les polymères électroluminescents à chaînes latérales réticulables proposés par la demanderesse et divulgués dans la Demande de Brevet n° 2 736 061.

La situation est différente avec la couche injectrice de trous car le dépôt de polymère émetteur par centrifugation
- ne peut se faire sur un film de petites molécules évaporées sous vide sans provoquer la redissolution complète de celui-ci ;
- et entraîne une redissolution plus ou moins complète de la couche injectrice de trous lorsque celle-ci est de type polymère PVK ou de type polymère dérivé du PTD de formule chimique :

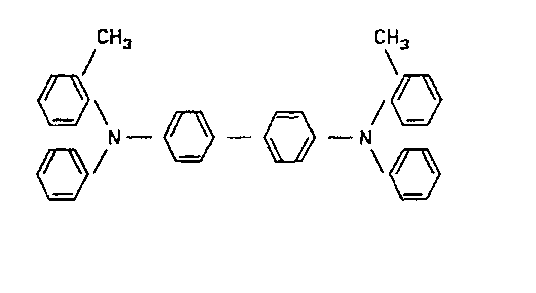

Dans ce contexte, l'invention a pour objet de nouveaux polymères photoréticulables et donc capables d'être rendus insolubles après dépôt par photoréticulation, et particulièrement adaptés à l'injection de trous dans des matériaux électroluminescents classiques.

Ces polymères sont des polymères photoréticulables à chaînes latérales attachées à un squelette, caractérisé en ce que :
- le squelette est de type polyacrylate, polyméthacrylate, polystyrène ou polyéthylène ;
- les chaînes latérales comprennent un groupe injecteur de trous, et un groupe photoréticulable, le groupe injecteur de trous étant une amine aromatique tertiaire de type 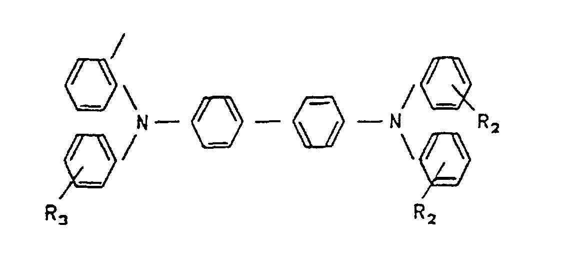
ou un carbazole 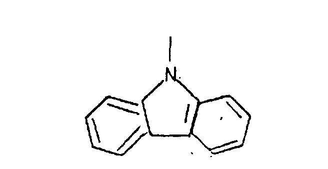 ou une pyrazoline 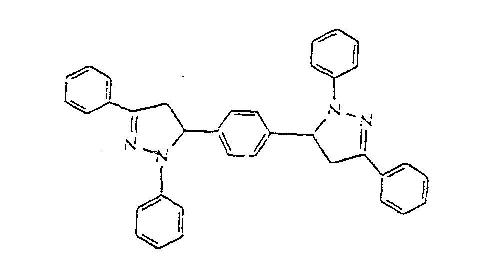 le groupe photoréticulable étant un dérivé de l'acide cinnamique

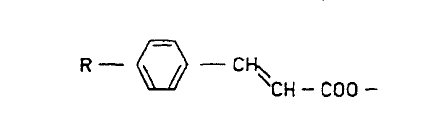

R = H, C_{y}H_{2y+1} avec 1 ≤ y ≤ 5

ou un dérivé de l'acide furylacrylique

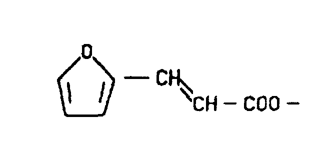

Selon une variation de l'invention, certaines chaînes latérales comportent un groupe injecteur de trous, les autres chaînes latérales comportant un groupe photoréticulable.

Selon une autre variante de l'invention, certaines chaînes latérales comportent un groupe photoréticulable attaché à un groupe injecteur de trous, les autres chaînes latérales comportant un groupe injecteur de trous.

L'invention sera mieux comprise et d'autres avantages apparaîtront à la lecture de la description qui va suivre et grâce aux figures annexées parmi lesquelles :
- la figure 1 illustre les niveaux d'énergie théoriques de la plus haute orbitale moléculaire occupée (HOMO) et de la plus basse orbitale moléculaire inocuppée (LUMO) pour un matériau électroluminescent, ainsi que le travail d'extraction de l'anode et le travail d'extraction de la cathode ;
- la figure 2 illustre les niveaux d'énergie correspondant à un cas réel de matériau électroluminescent compris entre anode et cathode ;
- la figure 3 illustre les niveaux d'énergie correspondant à un système bicouche comprenant un film électroluminescent et un film injecteur d'électrons (ETL) ;
- la figure 4 illustre les niveaux d'énergie correspondant à un système bicouche comprenant un film électroluminescent et un film injecteur de trous (HTL) ;
- la figure 5 illustre une variante de l'invention selon laquelle des châines latérales différentes supportent les groupes injecteurs de trous et les groupes photoréticulables ;
- la figure 6 illustre une variante de l'invention selon laquelle certaines chaînes latérales comportent à la fois des groupes injecteurs de trous et des groupes photoréticulables ;
- la figure 7 illustre un exemple de polymère selon la seconde variante, dans laquelle le groupe injecteur de trous est de type amine aromatique tertiaire ;
- la figure 8 illustre un exemple de polymère selon la seconde variante, dans laquelle le groupe injecteur de trous est de type carbazole ;
- la figure 9 illustre un exemple de polymère selon la seconde variante, dans laquelle le groupe injecteur de trous est de type pyrazoline ;
- la figure 10 illustre le schéma réactionnel relatif à la synthèse d'un premier exemple polymère selon l'invention ;
- la figure 11 illustre le schéma réactionnel relatif à la synthèse d'un second exemple de polymère selon l'invention ;
- la figure 12 illustre le schéma réactionnel de la synthèse d'un monomère précurseur d'un polymère selon l'invention, comprenant un groupe injecteur de trous de type amine aromatique.

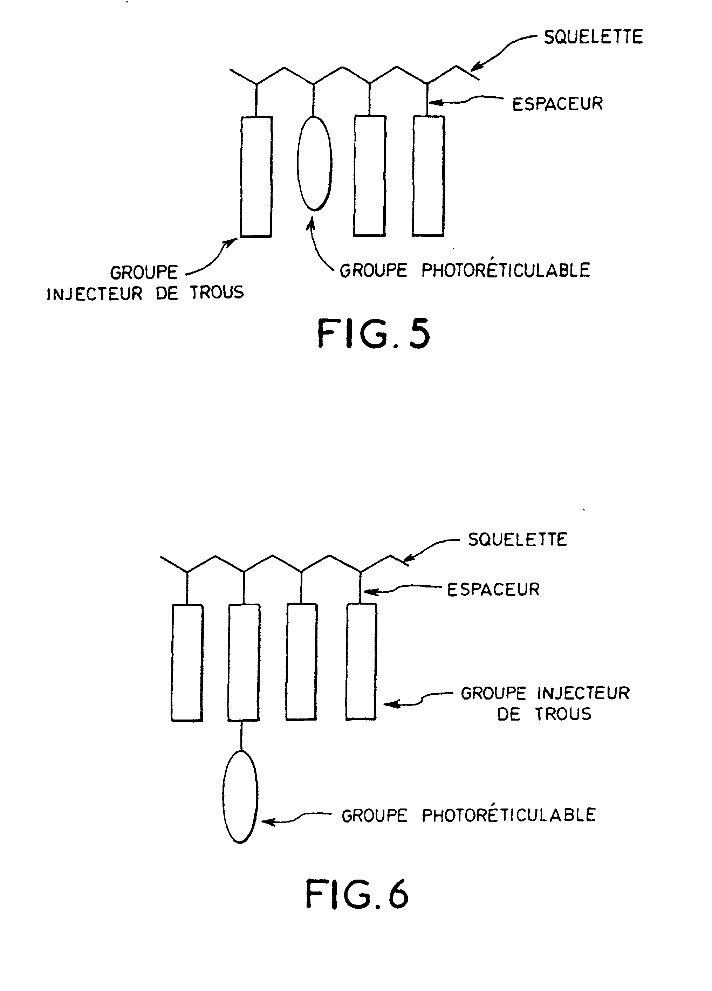

La figure 5 illustre une première variante de l'invention selon laquelle le groupe photoréticulable et le groupe injecteur de trous ne sont pas compris dans la même chaîne latérale. Selon cette variante, le groupe injecteur de trous peut être relié directement au squelette ou bien par l'intermédiaire d'un espaceur de type

―(―CH₂―)ₓ―O― avec 1 < x < 10

La figure 6 illustre une seconde variante de l'invention selon laquelle le groupe photoréticulable est attaché à un groupe injecteur de trous. Le groupe injecteur de trous peut être directement attaché au squelette, ou attaché par l'intermédiaire d'un espaceur de type

―(―CH₂―)ₓ―O― avec 1 < x < 10

comme dans la première variante de l'invention.

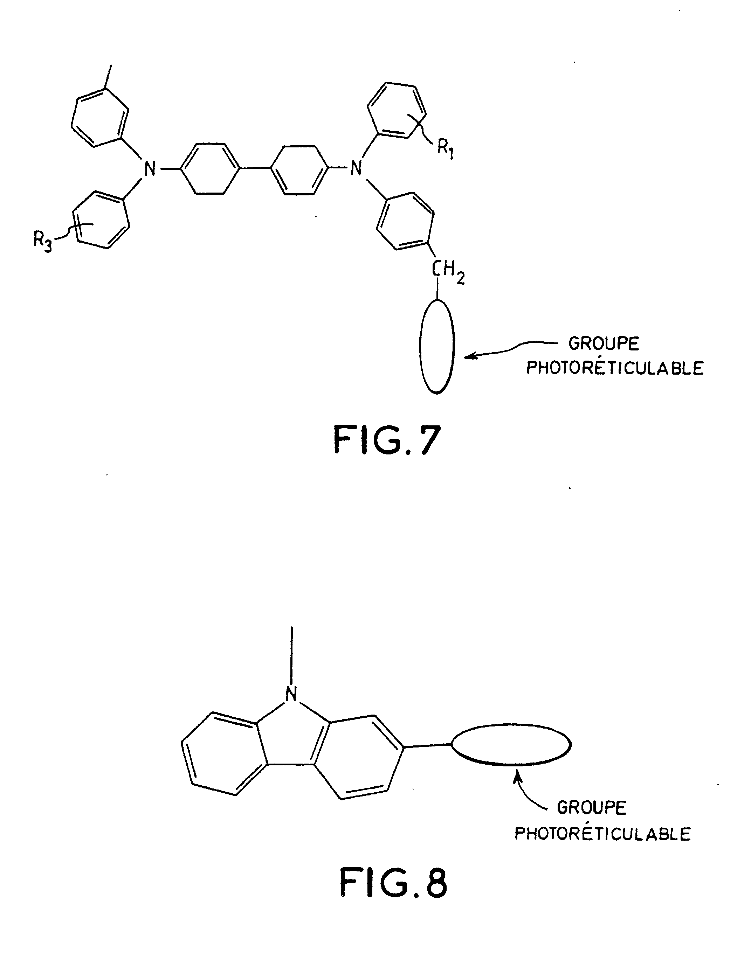

Lorsque le groupe injecteur de trous est de type amines aromatiques tertiaires, le groupe photoréticulable peut typiquement être greffé, tel que représenté en figure 7. Lorsque le groupe injecteur de trous est de type carbazole, le groupe photoréticulable peut typiquement être greffé tel que représenté en figure 8.

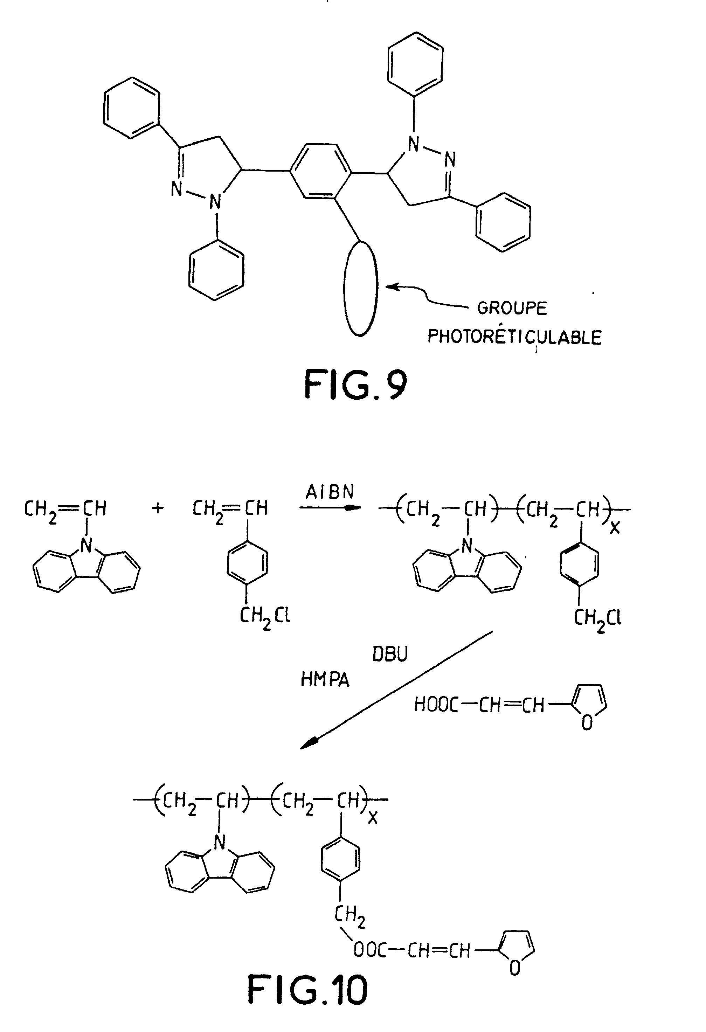

Lorsque le groupe injecteur de trous est de type pyrazoline, le groupe photoréticulable peut typiquement être greffé tel que représenté en figure 9.

Trois exemples conduisant à trois copolymères selon l'invention, sont décrits ci-après.

### Exemple 1

### Synthèse du poly(vinyl carbazole) co (4 furylacryloyloxyméthyl styrène) (copolymère I)

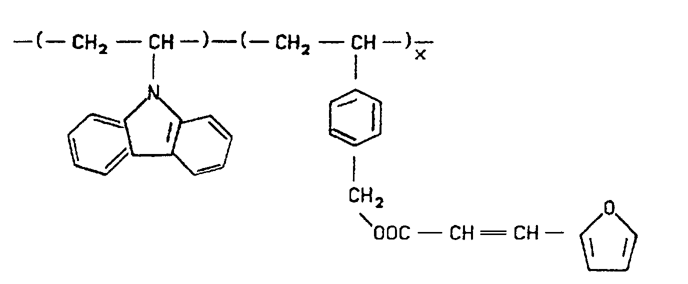

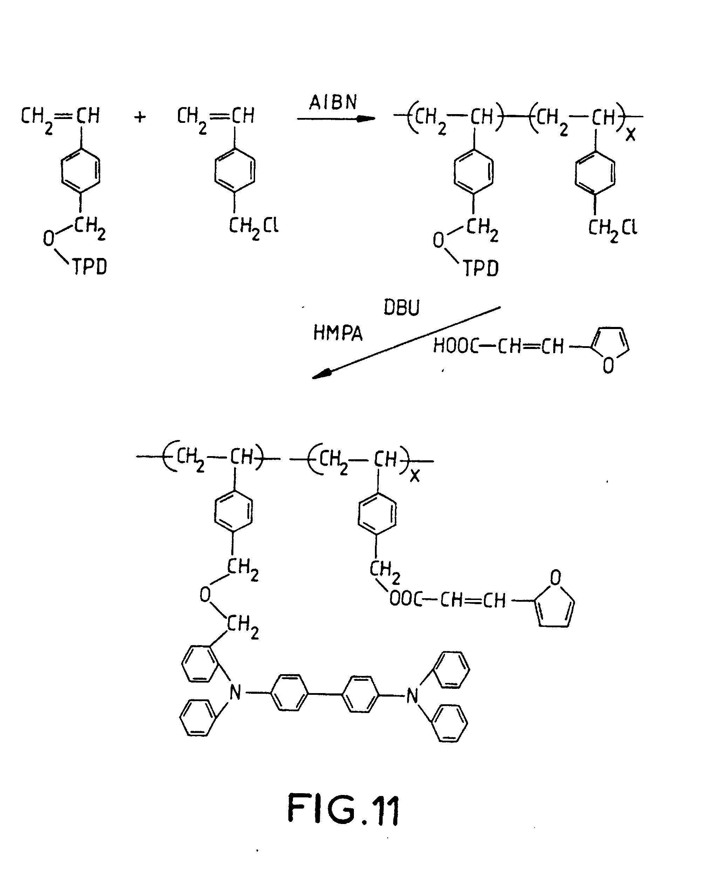

Le copolymère I est obtenu en deux étapes à partir du vinyl carbazole et du 4chlorométhyl styrène, comme illustré en figure 10.

### Synthèse du poly(vinylcarbazole) co (4chlorométhyl styrène)

Dans une ampoule préscellée, on introduit 1,5 g de vinyl carbazole, 0,131 g de 4chlorométhyl styrène, 15 ml de toluène et 14,15 mg d'AIBN.

La solution est dégazée 3 fois sous vide, puis l'ampoule est scellée sous vide. Le milieu réactionnel est chauffé pendant 25 heures à 65°C. Le polymère est précipité dans l'éther puis dans le méthanol.

### Synthèse du copolymère (I)

0,181 g d'acide furylacrylique et 0,2 g de DBU sont dissous dans 3 ml de DMPU. On agite pendant 1 heure à 50°C pour former le sel. 0,5 g de poly(vinylcarbazole) co (4chlorométhyl styrène) sont ensuite ajoutés au milieu réactionnel. Le mélange est agité pendant 8 heures à 50°C. Le copolymère (I) est précipité dans l'eau, puis dans le méthanol.

### Etude de la photoréticulation du copolymère (I)

Un film de copolymère (I) est déposé par centrifugation sur une lame de quartz. On étudie l'évolution de la densité du film en fonction du temps d'exposition à une lampe fluorescente ayant une densité de puissance de 1,5 mW/cm².

On voit qu'après 10 minutes d'irradiation, le film est insoluble dans le 1,1,2 trichloroéthane.

### Exemple 2 : Synthèse du poly(N,N,N' triphényl-N' (4 vinylbenzoyloxyméthylène phénylène) 1,1' diphényl-4,4' (diamine) co (4 furylacryloyloxyméthyl styrène) 76-24. Copolymère (II)

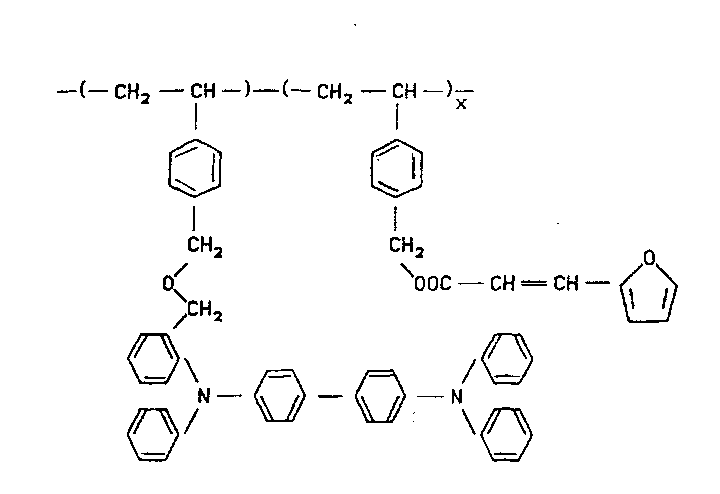

Le copolymère (II) est obtenu en deux étapes à partir du N,N,N' triphényl-N' (4 vinylbenzoyloxyméthylène phénylène) 1,1' diphényle-4,4' diamine et du 4chlorométhyl styrène, selon le schéma réactionnel illustré en figure 11.

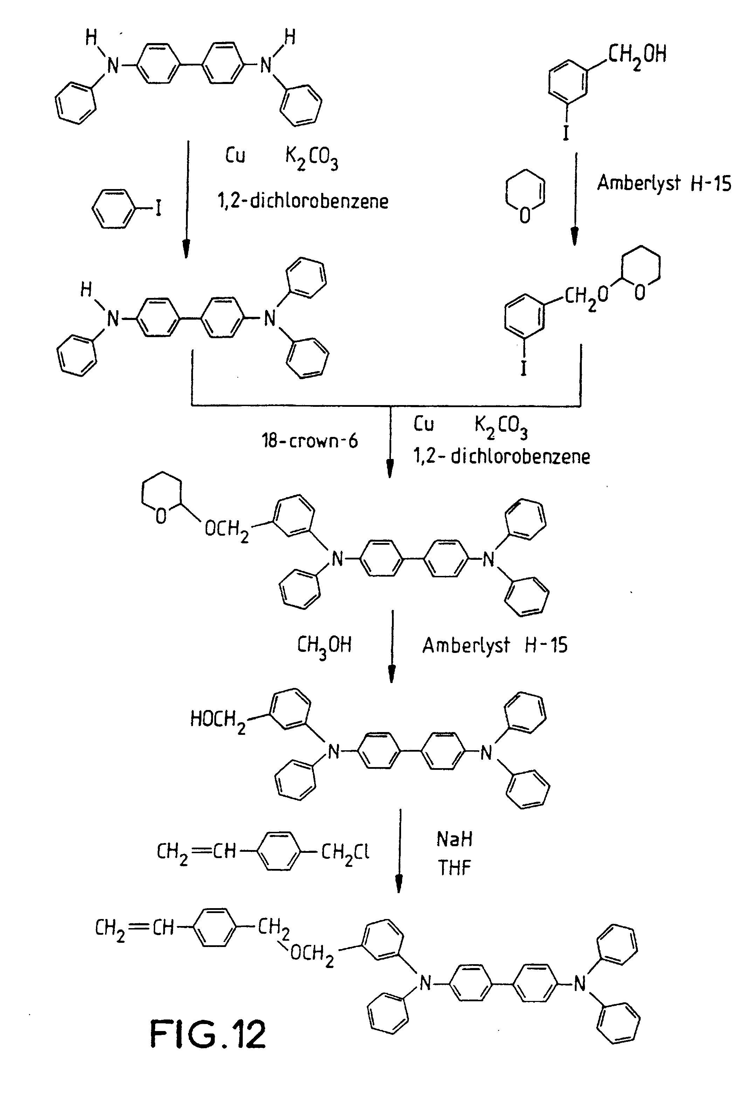

Le N,N,N' triphényl-N' (4 vinylbenzoyloxyméthylène phénylène) 1,1' diphényle-4,4' diamine (monomère amine) est obtenu en 5 étapes à partir du 3 iodo benzyl alcool et du N,N diphényl-1,1' diphényle-4,4' diamine, ces étapes étant illustrées en figure 12.

### N,N,N' triphényl-1,1' diphénylène 4,4' diamine

Dans un erlenmeyer de 250 ml avec agitation magnétique, on introduit 14 g de N,N, diphényl-1,1' diphénylène 4,4' diamine, 8,5 g d'iodo benzène, 22,9 g de carbonate de potassium, 1,05 g d'éther couronne, 18-65, 3 g de cuivre et 42 ml de 1,2 dichlorobenzène.

On chauffe à reflux sous courant d'azote pendant 16 h 30.

Le milieu réactionnel est filtré à chaud sur sable de Fontainebleau. Le solvant est éliminé du filtrat par distillation sous vide. Le produit brut marron pâteux se solidifie lorsqu'il est lavé au méthanol.

Le produit brut est purifié par chromatographie sur silice, éluant hexane 50-benzène 50. On obtient 6,18 g de produit pur. Rendement : 36,05 %. Point de fusion : 223°C.

### Tétrahydropyranyl éther d'alcool 3 iodobenzylique

Dans un erlenmeyer de 100 ml muni d'une agitation magnétique, on introduit 10 ml d'hexane et 1 g d'amberlyst 15. On mélange 9,84 g de 3 iodobenzylalcool, 4,5 g de 3,4 dihydro-2H-pyrane avec 10 ml d'hexane (le milieu est hétérogène). On additionne le mélange précédent dans l'erlenmeyer et on agit pendant 1 h 15 à T ambiante.

La phase liquide devient homogène.

L'amberlyst est éliminé par filtration. Le filtrat est évaporé à sec. Le produit brut est purifié par chromatographie sur silice éluant hexane puis benzène. On recueille 12,53 g de liquide pur.
Rendement : 93,8 %.

### Synthèse du N,N,N' triphényl-N' (3 hydroxyméthylne phénylène tétrahydropyranyl éther) 1,1' diphényle-4,4' diamine

Dans un erlenmeyer de 100 ml avec agitation magnétique, on introduit 6 g de N,N,N' triphényl-1,1' diphénylène 4,4' diamine, 5,09 g de tétrahydropyranyl éther d'alcool 3 iodobenzylique, 8,03 g de carbonate de potassium, 1,1 g d'éther couronne 18-6, 1,84 g de cuivre et 31 ml de 1,2 dichlorobenzène.

On chauffe à reflux sous courant d'azote pendant 19 heures.

Le milieu réactionnel est filtré à chaud sur sable de Fontainebleau. Le solvant est éliminé du filtrat par distillation sous vide. Le produit brut est purifié par chromatographie sur silice, éluant hexane 75-benzène 25 puis hexane 50-benzène 50 et hexane 25-benzène 75. On obtient 8,55 g de produit pur. Le produit pur est un liquide visqueux qui se solidifie lorsqu'il est mis sous vide.
Rendement : 97,5 %.

L'analyse thermique révèle que le produit est amorphe.

### Synthèse du N,N,N' triphényl-N' (3 hydroxyméthylène phénylène) 1,1' diphényle-4,4' diamine

Dans un erlenmeyer de 500 ml, muni d'une agitation magnétique, on dissout 8,3 g d'amine protégée dans 100 ml de dichlorométhane. Puis on ajoute 10 ml de méthanol et 2,43 g d'amberlyst 15. On chauffe à reflux pendant 3 heures. On laisse revenir le milieu réactionnel à température ambiante, on élimine l'amberlyst par filtration. Le filtrat est évaporé sous vide. Le produit brut est purifié par chromatographie sur silice, éluant dichlorométhane. On obtient 6,17 g de produit.
Rendement : 86,4 %.

Le produit présente une transition vitreuse à 61°C.

### Synthèse du N,N,N' triphényl-N' (4 vinylbenzoyloxyméthylène phénylène) 1,1' diphényle-4,4' diamine

Dans un tricol de 100 ml muni d'une agitation magnétique, d'un réfrigérant à reflux et d'un balayage d'argone, on introduit 30 ml de THF distillé sur sodium, puis 4,6 g d'hydrure de sodium. Enfin, on ajoute 3,1 g d'amine alcool. On chauffe à reflux pendant 1 heure sous un courant d'argon, on laisse refroidir à T ambiante et on ajoute rapidement 1,44 g de 4chlorométhyl styrène dissous dans 20 ml de THF. On chauffe à reflux pendant 36 heures.

On laisse revenir le milieu réactionnel à T ambiante et on ajoute 500 ml d'éther. On agite pendant 1 heure et on filtre l'insoluble. Le filtrat est évaporé à sec.

Le produit brut est purifi par chromatographie sur silice éluant hexane puis hexane 50 %-toluène 50 % (en volume). Le brut de colonne est lavé au méthanol. On obtient 3 g de solide.
Rendement : 78,8 %.
Point de fusion : 104°C.

### Synthèse du poly(N,N,N' triphényl-N' (4 vinylbenzoyloxyméthylène phénylène) 1,1' diphényle-4,4' diamine co (4 chlorométhyl styrène)

Dans une ampoule préscellée, on introduit 0,634 g de monomère amine, 0,051 g de 4chlorométhyl styrène, 5 ml de toluène et 4,37 mg d'AIBN.

La solution est dégazée 3 fois sous vide, puis l'ampoule est scellée sous vide. Le milieu réactionnel est chauffé pendant 25 heures à 65°C. Le polymère est précipité dans un mélange éther-méthanol (43 % en volume) puis dans l'éther.
Rendement : 62,8 %.
Tg : 129°C.

### Synthèse du copolymère (II)

0,135 g d'acide furylacrylique et 0,15 g de DBU sont dissous dans 2 ml de HMPA. On agite pendant 1 heure à 40°C pour former le sel. 0,4 g de poly (N,N,N' triphényl-N' (4 vinylbenzoyloxyméthylène phénylène) 1,1' diphényle-4,4' diamine) co (4chlorométhyl styrène) sont ensuite ajoutés au milieu réactionnel. Le mélange est agité pendant 7 heures à 40°C. Le copolymère (II) est précipité dans l'eau, puis dans le méthanol.
Rendement : 121°C.

La teneur en furyl acrylate déterminée par RMN est de 24 % en mole.

### Exemple 3 : synthèse du poly(N,N,N' triphényl-N' (4 vinylbenzoyloxyméthylène phénylène) 1,1' diphényle-4,4' diamine) co (4 furylacryloyloxyméthyl styrène). 93-7 copolymère (III).

### Synthèse du poly(N,N,N' triphényl-N (4 vinylbenzoyloxyméthylène phénylène) 1,1' diphényle-4,4' diamine co (4chlorométhyl styrène)

Dans une ampoule préscellée, on introduit 0,634 g de monomère amine, 0,025 g de 4chlorométhyl styrène, 4 ml de toluène et 4,37 mg d'AIBN.

La solution est dégazée 3 fois sous vide, puis l'ampoule est scellée sous vide. Le milieu réactionnel est chauffé pendant 25 heures à 65°C. Le polymère est précipité dans le méthanol puis dans l'éther.

### Synthèse du copolymère (III)

0,065 g d'acide furylacrylique et 0,075 g de DBU sont dissous dans 3 ml de HMPA. On agite pendant 1 heure à 40°C pour former le sel. 0,45 g de poly (N,N,N' triphényl-N' (4 vinylbenzoyloxyméthylène phénylène) 1,1' diphényle-4,4' diamine) co (4chlorométhyl styrène) sont ensuite ajoutés au milieu réactionnel. Le mélange est agité pendant 7 heures à 40°C. Le copolymère (III) est précipité dans l'eau, puis dans le méthanol.

La teneur en furyl acrylate déterminée par RMN est de 7 % en mole.

### Etude dela photoréticulation du copolymère (III)

Un film de copolymère (III) est déposé par centrifugation sur une lame de quartz. On étudie l'évolution de la densité du film en fonction du temps d'exposition à une lampe fluorescente ayant une densité de puissance de 1,5 mW/cm².

On voit qu'après 10 minutes d'irradiation, 88 % du film est insoluble dans le 1,1,2 trichloro éthane.

Une diode électroluminescente bicouche a été réalisée en utilisant le copolymère (II) comme injecteur de trous et le dérivé suivant du polystyrène comme émetteur.

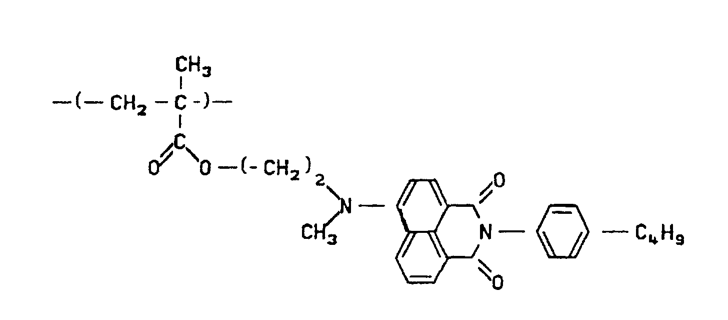

Le film injecteur de trous a été réticulé pendant 10 minutes par irradiation sous UV, puis le polymère émetteur a été déposé par spin coating sur le copolymère (II). 100 cd/m² ont été obtenus avec une densité de courant de 70 mA/cm² sous une tension de 27 V.

## Revendications

1. Polymère photoréticulable à chaînes latérales attachées à un squelette, **caractérisé en ce que** :
- le squelette est de type polyacrylate, polyméthacrylate, polystyrène ou polyéthylène ;
- les chaînes latérales comprennent un groupe injecteur de trous, et un groupe photoréticulable, le groupe injecteur de trous étant une amine aromatique tertiaire de type 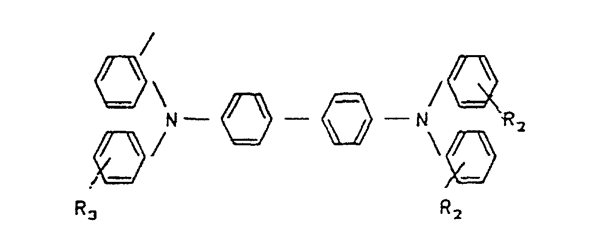
ou un carbazole 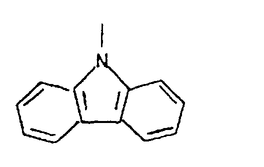 ou une pyrazoline 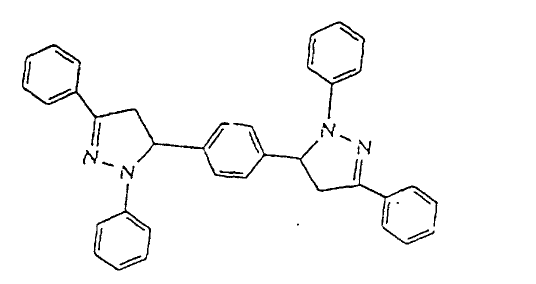 le groupe photoréticulable étant un dérivé de l'acide cinnamique 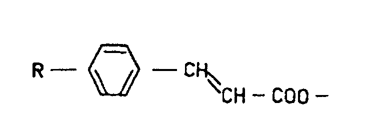
R = H₂CyH_{2y+1}O
ou un dérivé de l'acide furylacrylique

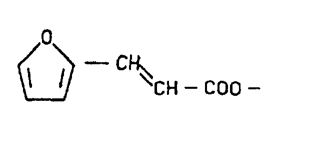

2. Polymère photoréticulable à chaînes latérales selon la revendication 1, **caractérisé en ce que** certaines chaînes latérales comportent un groupe injecteur de trous, les autres chaînes latérales comportant un groupe photoréticulable.

3. Polymère photoréticulable à chaînes latérales selon la revendication 1, **caractérisé en ce que** certaines chaînes latérales comportent un groupe photoréticulable attaché à un groupe injecteur de trous, les autres chaînes latérales comportant un groupe injecteur de trous.

4. Polymère à chaînes latérales selon l'une des revendications 1 à 3, **caractérisé en ce que** les groupes injecteurs de trous sont reliés au squelette par un espaceur de type
―(―CH₂―)ₓ―O― avec 1 < x < 10

5. Polymère à chaînes latérales selon l'une des revendications 1 à 4, **caractérisé en ce que** la teneur en groupe photoréticulable est comprise entre 1 et 25 % en mole.

## Patentansprüche

1. Durch Licht vernetzbares Polymer mit an ein Skelett gebundenen Seitenketten, **dadurch gekennzeichnet, daß**
- das Skelett vom Polyacrylat-, Polymetacrylat-, Polystyrol- oder Polyethylentyp ist,
- die Seitenketten eine Löcher injizierende Gruppe und eine durch Licht vernetzbare Gruppe enthalten, wobei die Löcher injizierende Gruppe ein tertiäres aromatisches Amin des Typs
oder ein Carbazol 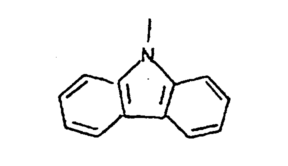 oder ein Pyrazolin 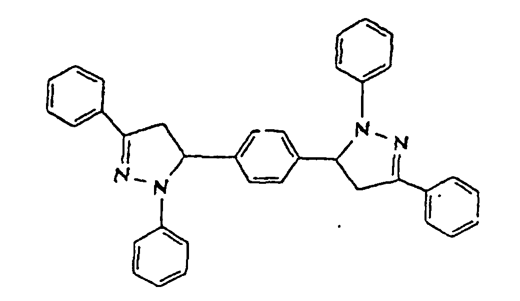 und die durch Licht vernetzbare Gruppe ein Derivat der Zimtsäure 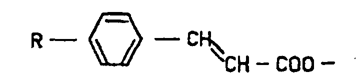
R = H₂C_{y}H_{2y+1}O
oder ein Derivat der Furylacrylsäure
ist.

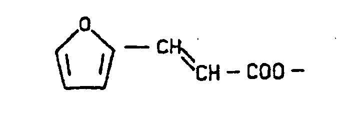

2. Durch Licht vernetzbares Polymer mit Seitenketten nach Anspruch 1, **dadurch gekennzeichnet, daß** bestimmte Seitenketten eine Löcher injizierende Gruppe aufweisen, während die anderen Seitenketten eine durch Licht vernetzbare Gruppe enthalten.

3. Durch Licht vernetzbares Polymer mit Seitenketten nach Anspruch 1, **dadurch gekennzeichnet, daß** bestimmte Seitenketten eine durch Licht vernetzbare Gruppe aufweisen, die an eine Löcher injizierende Gruppe gebunden ist, während die anderen Seitenketten eine Löcher injizierende Gruppe enthalten.

4. Polymer mit Seitenketten nach einem der Ansprüche 1 bis 3, **dadurch gekennzeichnet, daß** die Löcher injizierenden Gruppen an das Skelett durch Abstandsglieder des Typs
-(-CH₂-)ₓ-O- mit 1<x<10
gebunden sind.

5. Polymer mit Seitenketten nach einem der Ansprüche 1 bis 4, **dadurch gekennzeichnet, daß** der Anteil der durch Licht vernetzbaren Gruppe zwischen 1 und 25 mol% liegt.

## Claims

1. Photocrosslinkable polymer having side chains attached to a backbone, **characterized in that**:
- the backbone is of the polyacrylate, polymethacrylate, polystyrene or polyethylene type;
- the side chains comprise a hole-injecting group and a photocrosslinkable group, the hole-injecting group being a tertiary aromatic amine of type 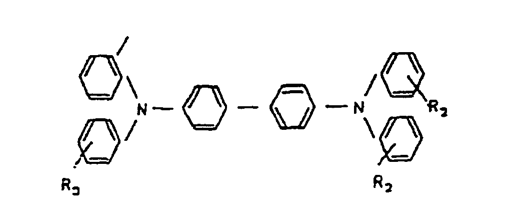 or a carbazole 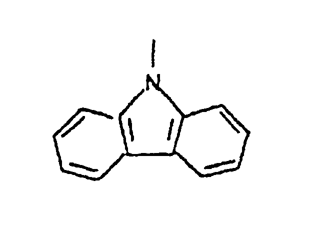 or a pyrazoline 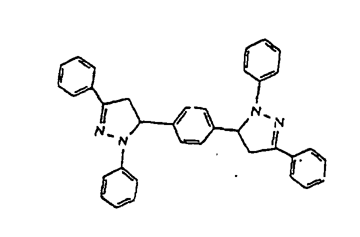 the photocrosslinkable group being a derivative of cinnamic acid 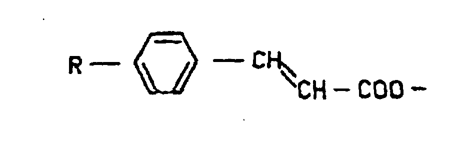 in which R = H₂C_{y}H_{2y+1}O
or a derivative of furylacrylic acid

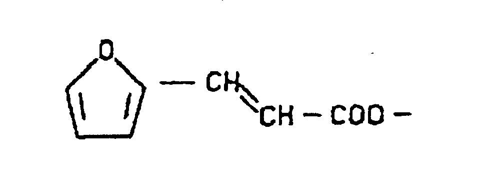

2. Photocrosslinkable side-chain polymer according to Claim 1, **characterized in that** some of the side chains contain a hole-injecting group, the other side chains containing a photocrosslinkable group.

3. Photocrosslinkable side-chain polymer according to Claim 1, **characterized in that** some of the side chains contain a photocrosslinkable group attached to a hole-injecting group, the other side chains containing a hole-injecting group.

4. Side-chain polymer according to one of Claims 1 to 3, **characterized in that** the hole-injecting groups are linked to the backbone via a spacer of type 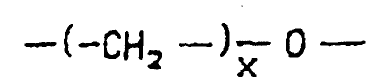 with 1 < x < 10

5. Side-chain polymer according to one of Claims 1 to 4, **characterized in that** the photocrosslinkable group content is between 1 and 25 mol%.
